# EUROPEAN PATENT APPLICATION

(11) **EP 1 950 851 A1**
(43) Date of publication of application: **30.07.2008**
(21) Application number: 06811391.9
(22) Date of filing: 06.10.2006
(51) Int. Cl.: H01R 43/16, C23C 10/28, C23C 28/02, C25D 1/00, H01R 13/03, H01R 13/24, H01R 33/76

(54) **SPIRAL CONTACT AND PROCESS FOR PRODUCING THE SAME**

(30) Priority: 01.11.2005 JP 2005318661
(71) Applicant: Advanced Systems Japan Inc., Tokyo 181-0013 (JP)
(72) Inventor: HIRAI, Yukihiro, Tokyo 1840013 (JP)
(74) Representative: Thun, Clemens
(86) International application number: PCT/JP2006/320064
(87) International publication number: WO 2007/052438

(57) **Abstract**

To provide a producing method of a spiral contact that exhibits, even in a hot environment, low permanent set in fatigue, excellent spring characteristic and excellent electrical conductivity. In the producing method in which atoms of a dissimilar metal are diffused and infiltrated into a surface layer of the spiral contact (7) by being heated in a state where the spiral contact (7) is brought into contact with the dissimilar metal, by heating titanium (or aluminum) deposited on the surface of the spiral contact, copper of a Cu substrate (1) and nickel which is a core material of the spiral contact (7), atoms of Ti (or Al) and atoms of Cu are diffused and infiltrated into the surface layer of the core material (Ni) to form alloys (7c) and (7d). The heating temperature is set such that a lower limit thereof is the temperature corresponding to 0.4 times the absolute temperature of the melting point of the metal with the highest melting point among the core metal and dissimilar metal brought in contact with each other while an upper limit thereof is the absolute temperature of the melting point of the metal with the lowest melting point among the core metal and dissimilar metal brought in contact with each other. Further, Ni (as a barrier material) is formed between the core material and the Cu substrate, and Cu is used as the core material.

## Description

### [Field of the Invention]

The present invention relates to a spiral contact that exhibits, even in a hot environment, low permanent set in fatigue, excellent spring characteristic and excellent electrical conductivity, and more particularly to a spiral contact in which a dissimilar metal is diffused and infiltrated into a surface layer of the spiral contact to form an alloy of the dissimilar metal so that the characteristic of the spiral contact is improved, as well as to a producing method of the spiral contact.

### [Related Art]

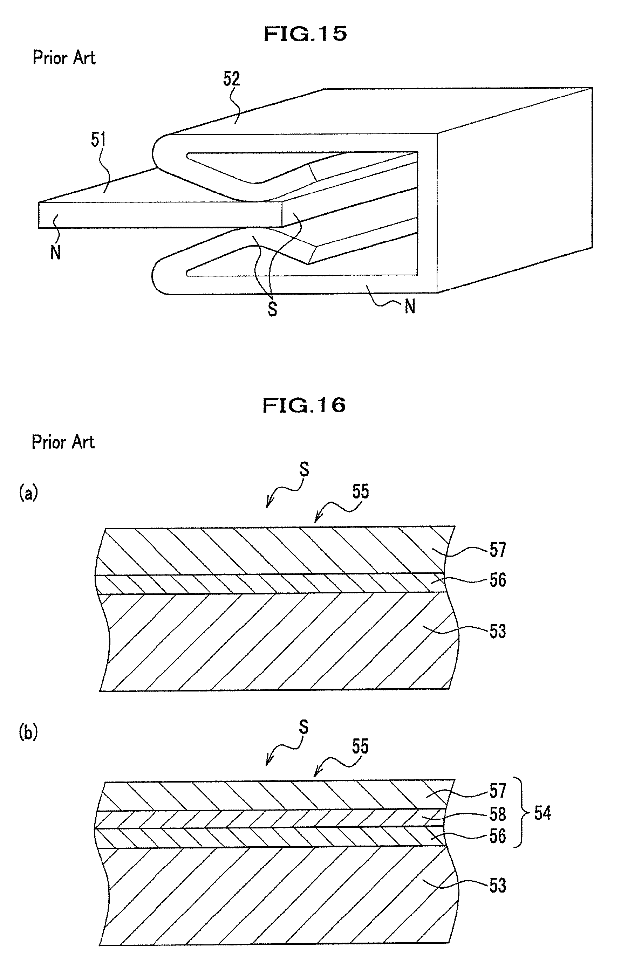

Fig. 15 is an enlarged perspective view showing a connector terminal according to a conventional art. The connector terminal is used, for example, as a connector for an automobile. As shown in Fig. 15, the connector terminal is made of a copper alloy thin plate and includes at least a male terminal 51 and a female terminal 52 capable of engaging with each other.

The male terminal 51 and the female terminal 52 each include a sliding portion S and an other portion N. The sliding portion S has a Vickers' hardness of 60 to 700 HV, and the other portion N has a Vickers' hardness of 45 to 250 HV.
Further, the difference of the Vicker's hardness between the male terminal 51 and the female terminal 52, in the sliding portions S, is 15 HV or more.
By controlling the difference of the Vicker's hardness between the sliding portions S of the male terminal 51 and the female terminal 52 to 15 HV or more, inserting force (inserting/extracting force) can be reduced. Thus, the connector terminal is excellent in contact stability compared to the case where the male terminal 51 and the female terminal 52 have the same hardness, and therefore the force needed to perform inserting/extracting operation is reduced.

In other words, when inserting the male terminal 51 into the female terminal 52, abrasion will be caused between the sliding portions S of the two terminals. In the case where the male terminal 51 and the female terminal 52 are soft and have almost the same hardness, deformation resistance will become high, and therefore the inserting force will increase. While in the case where the male terminal 51 and the female terminal 52 are hard and have almost the same hardness, the resistance against the abrasion will become high, and therefore the inserting force will increase. However, in the case where a difference of hardness exists between the male terminal 51 and the female terminal 52, the soft side is apt to be abraded, and therefore the inserting force will decrease. In such a case, the inserting force can be reduced if the difference of the Vicker's hardness between the both terminals is controlled to 15 HV or more.
With such an arrangement, the inserting/extracting resistance of the connector is reduced and therefore the necessary inserting force when assembling the connector is reduced. Thus, not only the working efficiency of the assembly operation can be improved, but also the fatigue degree of the workers can be reduced.

In Fig. 16, (a) and (b) are enlarged views of the sliding portions, and show surfaces of Cu alloy substrates, each surface having a plating layer and an alloy formed by thermal diffusion.
As shown in (a) of Fig. 16, a plating process using one or more kinds of metals selected from Cu, Ag, Ni, PbZn, P, B, Cr, Mn, Fe, Co, Pd, Pt, Ti, Zr, Hf, V, Nb, Ta, Mo, W, In, C, S, Au, Al, Si, Sb, Bi, and Te is performed to the surface of the Cu alloy substrate to form a metal thin plate 55. By performing the plating process, an alloy formed by the Cu alloy substrate 53 and the metal selected from the above metal group is formed, so that the plated surface is hardened to a predetermined hardness.

As shown in (a) and (b) of Fig. 16, in the sliding portions (see Fig. 15) of the male terminal 51 and the female terminal 52, a Cu-Sn alloy 58 is formed between a pure Sn layer 57 and a Cu layer 56 (or between the Cu layer 56 and the substrate 53) by thermal diffusion into each other until thickness of the pure Sn layer 57 becomes less than 0.6 *µ*m, so that a surface layer 54 of the substrate 53 is formed by the Cu layer 56, the pure Sn layer 57 and the alloy 58.

Thus, good fitting property and stable contact of the terminal and connector used as electronic circuit components can be achieved, and contact resistance can be reduced. Further, the inserting force can be reduced, and insertability/extractability can be improved. Further, assembly efficiency of the automobile assembly process can be improved. Further, since gripping force does not change, the connector can be securely installed with no concern that the connection might be disengaged due to the vibration of the engine (see Patent Document 1).
[Patent Document 1] Japanese Patent Laid-Open Publication No. 2004-179055 (Paragraph [0032], Fig. 1)

However, a problem with such an art is that it will take long time to form a thin film of the dissimilar metal by performing a plating process and then performing a thermal diffusion process.
Further, when placing the thin film of the dissimilar metal onto a metal material, into which the dissimilar metal is desired to be diffused, in order to form an alloy in the surface layer of the metal material, there is concern that the metals brought into contact with each other might be melted into each other.

In view of the above problems, it is an object of the present invention to provide a spiral contact and a producing method thereof, in which the spiral contact not only has the characteristic of core metal but also has the characteristic of the dissimilar metal, and therefore the spiral contact exhibits, even in a hot environment, low permanent set in fatigue, excellent spring characteristic and excellent electrical conductivity.

### [Disclosure of the Invention]

A producing method of a spiral contact according to a first aspect of the present invention is a method in which at least one dissimilar metal different from a core metal of the spiral contact is diffused and infiltrated into a surface layer of the core metal, wherein atoms of the dissimilar metal are diffused and infiltrated into the surface layer of the core metal by being heated in a state where the core metal is brought into contact with the dissimilar metal.

A producing method of a spiral contact according to a second aspect of the present invention is a method in which at least one dissimilar metal different from a core metal of the spiral contact is diffused and infiltrated into a surface layer of the core metal, wherein atoms of the dissimilar metal are diffused and infiltrated into the surface layer of the core metal by being heated in a pressurized environment in a state where the core metal is brought into contact with the dissimilar metal.

According to a third aspect of the present invention, in the producing method of the spiral contact according to the first or second aspect of the present invention, a heating temperature is set such that a lower limit thereof is the temperature corresponding to 0.4 times the absolute temperature of the melting point of the metal with the highest melting point among the core metal and dissimilar metal brought in contact with each other while an upper limit thereof is the absolute temperature of the melting point of the metal with the lowest melting point among the core metal and dissimilar metal brought in contact with each other.

According to a fourth aspect of the present invention, in the producing method of the spiral contact according to the second aspect of the present invention, the pressure of the pressurized environment is set to be ≥0.1 MPa but ≤10.0 MPa.

According to a fifth aspect of the present invention, in the producing method of the spiral contact according to the first or second aspect of the present invention, the dissimilar metal is titanium (Ti) which is deposited onto the surface of the core metal by a physical vapor deposition.

According to a sixth aspect of the present invention, in the producing method of the spiral contact according to the first or second aspect of the present invention, the dissimilar metal is aluminum (Al) which is deposited onto the surface of the core metal by a physical vapor deposition.

According to a seventh aspect of the present invention, in the producing method of the spiral contact according to any one of the first, second and fourth aspects of the present invention, the core metal is constituted by nickel (Ni) plated and deposited on a copper (Cu) substrate, and atoms of copper (Cu) are diffused and infiltrated into the surface layer of the core metal by being heated in a state where the copper (Cu) substrate and the core metal are brought into contact with each other.

According to an eighth aspect of the present invention, in the producing method of the spiral contact according to the first or second aspect of the present invention, if the core metal is constituted by nickel (Ni) plated and deposited on a copper (Cu) substrate and the dissimilar metal is constituted by titanium (Ti), then heating temperature is between 779K and 1358K.

According to a ninth aspect of the present invention, in the producing method of the spiral contact according to the first or second aspect of the present invention, if the core metal is constituted by nickel (Ni) plated and deposited on a copper (Cu) substrate and the dissimilar metal is constituted by aluminum (Al) , then the heating temperature is between 691K and 934K.

According to a tenth aspect of the present invention, in the producing method of the spiral contact according to any one of the first, second and fourth aspects of the present invention, the core metal is constituted by copper (Cu) plated and deposited on a barrier material previously plated and deposited on a copper (Cu) substrate, and atoms of the barrier material are diffused and infiltrated into the surface layer of the core metal by being heated in a state where the copper (Cu) substrate, the barrier material and the core metal are laminated.

According to an eleventh aspect of the present invention, in the producing method of the spiral contact according to the tenth aspect of the present invention, if the barrier material is constituted by a nickel (Ni) plating, the core metal is constituted by copper (Cu) plated and deposited on the nickel (Ni) plating, and the dissimilar metal is constituted by titanium (Ti), then the heating temperature is between 779K and 1358K.

According to an twelfth aspect of the present invention, in the producing method of the spiral contact according to the tenth aspect of the present invention, if the barrier material is constituted by a nickel (Ni) plating, the core metal is constituted by copper (Cu) plated and deposited on the nickel (Ni) plating, and the dissimilar metal is constituted by aluminum (Al), then the heating temperature is between 691K and 934K.

A spiral contact according to a thirteenth aspect of the present invention is produced by the producing method of the spiral contact according to any one of the first, second, fourth, eleventh and twelfth aspects of the present invention.

According to the first aspect of the present invention, since at least one dissimilar metal different from a core metal of the spiral contact is diffused and infiltrated into a surface layer of the core metal in a hot environment, the core metal forming the spiral contact also has the characteristic of the dissimilar metal, and therefore it is possible to obtain a spiral contact that exhibits, even in a hot environment, low permanent set in fatigue, excellent spring characteristic and excellent electrical conductivity.

According to the second aspect of the present invention, since at least one dissimilar metal different from a core metal of the spiral contact is diffused and infiltrated into a surface layer of the core metal in a heated and pressurized environment, the core metal forming the spiral contact also has the characteristic of the dissimilar metal, and therefore it is possible to obtain a spiral contact that exhibits, even in a hot environment, low permanent set in fatigue, excellent spring characteristic and excellent electrical conductivity.

According to the third aspect of the present invention, the heating temperature is set such that the lower limit thereof is the temperature corresponding to 0.4 times the absolute temperature of the melting point of the metal with the highest melting point among the core metal and the dissimilar metal brought in contact with each other while the upper limit thereof is the absolute temperature of the melting point of the metal with lowest melting point among the core metal and dissimilar metal brought in contact with each other, therefore it is possible to form the alloy only in the surface layer of the spiral contact in a short time.

According to the fourth aspect of the present invention, the pressure of the pressurized environment is set to be ≥0.1 MPa but ≤10.0 MPa, therefore it is possible to form the alloy only in the surface layer of the spiral contact in a short time.

According to the fifth aspect of the present invention, since the dissimilar metal is titanium (Ti) which is deposited onto the surface of the core metal by the physical vapor deposition, the alloy can be formed only in the surface layer in a short time, the core metal forming the spiral contact also has the characteristic of the dissimilar metal, and therefore it is possible to obtain a spiral contact that exhibits, even in a hot environment, low permanent set in fatigue and excellent spring characteristic.

According to the sixth aspect of the present invention, since the dissimilar metal is aluminum (Al) which is deposited onto the surface of the core metal by the physical vapor deposition., the alloy can be formed only in the surface layer in a short time, the core metal forming the spiral contact also has the characteristic of the dissimilar metal, and therefore it is possible to obtain a spiral contact that exhibits, even in a hot environment, low permanent set in fatigue and excellent spring characteristic.

According to the seventh aspect of the present invention, the core metal is constituted by nickel (Ni) plated and deposited on the copper (Cu) substrate, and atoms of copper (Cu) are diffused and infiltrated into the surface layer of the core metal by being heated in a state where the copper (Cu) substrate and the core metal are brought into contact with each other, the alloy can be formed only in the surface layer in a short time, the core metal forming the spiral contact also has the characteristic of the dissimilar metal, and therefore it is possible to obtain a spiral contact that exhibits excellent electrical conductivity.

According to the eighth aspect of the present invention, if the core metal is constituted by nickel (Ni) plated and deposited on a copper (Cu) substrate and the dissimilar metal is constituted by titanium (Ti), then the heating temperature is between 779K and 1358K. Therefore the alloy can be formed only in the surface layer in a short time, and the core metal forming the spiral contact also has the characteristic of the dissimilar metal, and therefore it is possible to obtain a spiral contact that exhibits, even in a hot environment, low permanent set in fatigue, excellent spring characteristic and excellent electrical conductivity.

According to the ninth aspect of the present invention, if the core metal is constituted by nickel (Ni) plated and deposited on a copper (Cu) substrate and the dissimilar metal is constituted by aluminum (Al), then the heating temperature is between 691K and 934K. Thereby the alloy can be formed only in the surface layer in a short time, and the core metal forming the spiral contact also has the characteristic of the dissimilar metal, and therefore it is possible to obtain a spiral contact that exhibits, even in a hot environment, low permanent set in fatigue, excellent spring characteristic and excellent electrical conductivity.

According to the tenth aspect of the present invention, the core metal is constituted by copper (Cu) plated and deposited on a barrier material previously plated and deposited on a copper (Cu) substrate, and atoms of the barrier material are diffused and infiltrated into the surface layer of the core metal by being heated in a state where the copper (Cu) substrate, the barrier material and the core metal are laminated. Thereby the alloy can be formed only in the surface layer in a short time, and the core metal forming the spiral contact also has the characteristic of the dissimilar metal, and therefore it is possible to obtain a spiral contact that exhibits, even in a hot environment, low permanent set in fatigue, excellent spring characteristic and excellent electrical conductivity.

According to the eleventh aspect of the present invention, if the barrier material is constituted by the nickel (Ni) plating, the core metal is constituted by copper (Cu) plated and deposited on the nickel (Ni) plating, and the dissimilar metal is constituted by titanium (Ti), then the heating temperature is between 779K and 1358K. Thereby the alloy can be formed only in the surface layer in a short time, and the core metal forming the spiral contact also has the characteristic of the dissimilar metal, and therefore it is possible to obtain a spiral contact that exhibits, even in a hot environment, low permanent set in fatigue, excellent spring characteristic and excellent electrical conductivity.

According to the twelfth aspect of the present invention, if the barrier material is constituted by a nickel (Ni) plating, the core metal is constituted by copper (Cu) plated and deposited on the nickel (Ni) plating, and the dissimilar metal is constituted by aluminum (Al), then the heating temperature is between 691K and 934K. Thereby the alloy can be formed only in the surface layer in a short time, and the core metal forming the spiral contact also has the characteristic of the dissimilar metal, and therefore it is possible to obtain a spiral contact that exhibits, even in a hot environment, low permanent set in fatigue, excellent spring characteristic and excellent electrical conductivity.

According to the thirteenth aspect of the present invention, it is possible to obtain a spiral contact produced by the producing method of the spiral contact according to any one of the first, second, fourth, eleventh and twelfth aspects of the present invention.

### [Brief Description of Drawings]

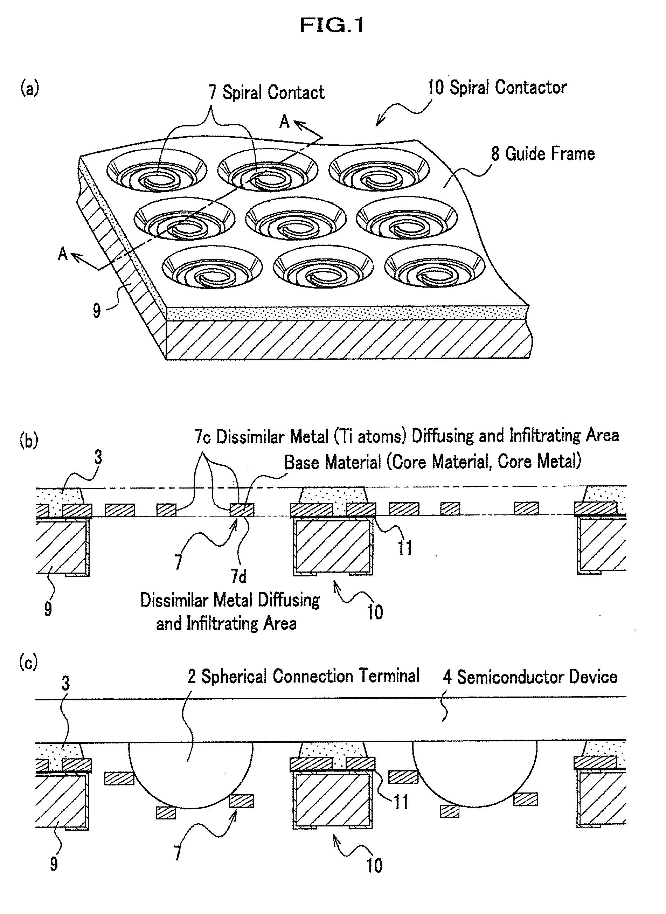

Fig. 1 includes (a), (b) and (c), in which (a) is a perspective view schematically showing spiral contacts according to a first embodiment, (b) and (c) show a cross section taken along line A-A of (a) in which (c) shows a state where a semiconductor device having spherical connection terminals is inserted into the spiral contacts shown in (b);

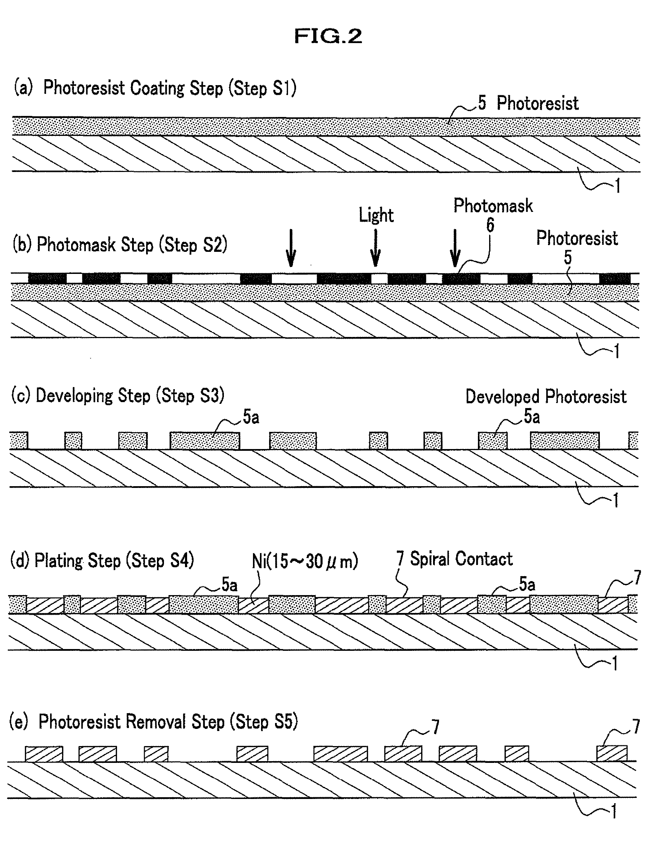

Fig. 2 is a process cross section explaining producing method of the spiral contact according to the first embodiment, in which (a) explains a photoresist coating step, (b) explains a photomask step, (c) explains a developing step, (d) explains a plating step, and (e) explains a photoresist removal step;

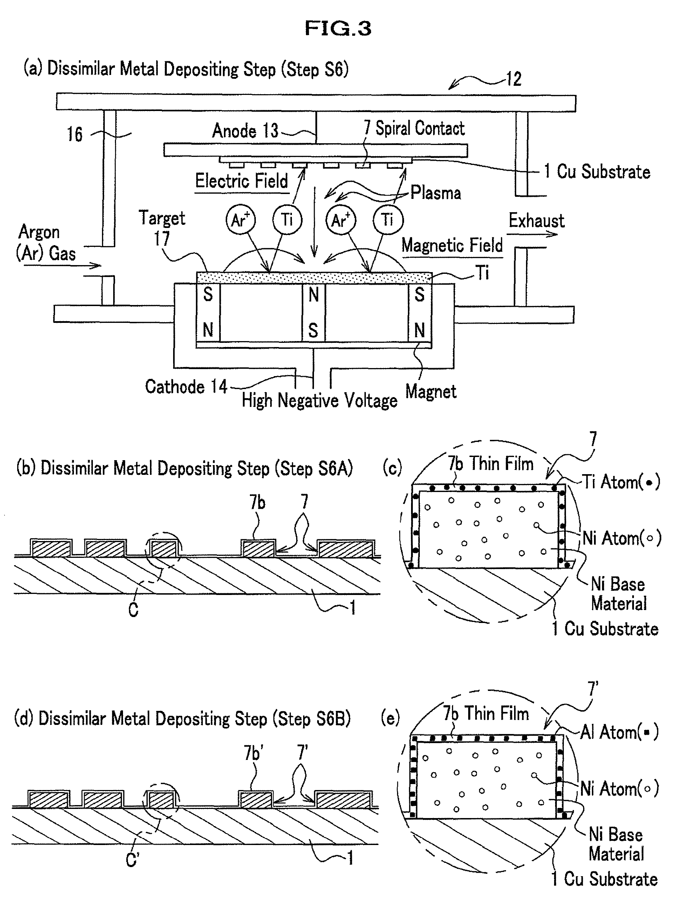

Fig. 3 includes (a), (b), (c), (d) and (e), in which (a) is a process cross section explaining a producing method of the spiral contact according to the first embodiment, (b) and (d) respectively explain dissimilar metal depositing steps, and (c) and (e) are enlarged schematic illustrations of a portion C and a portion C' respectively shown in (c) and (e);

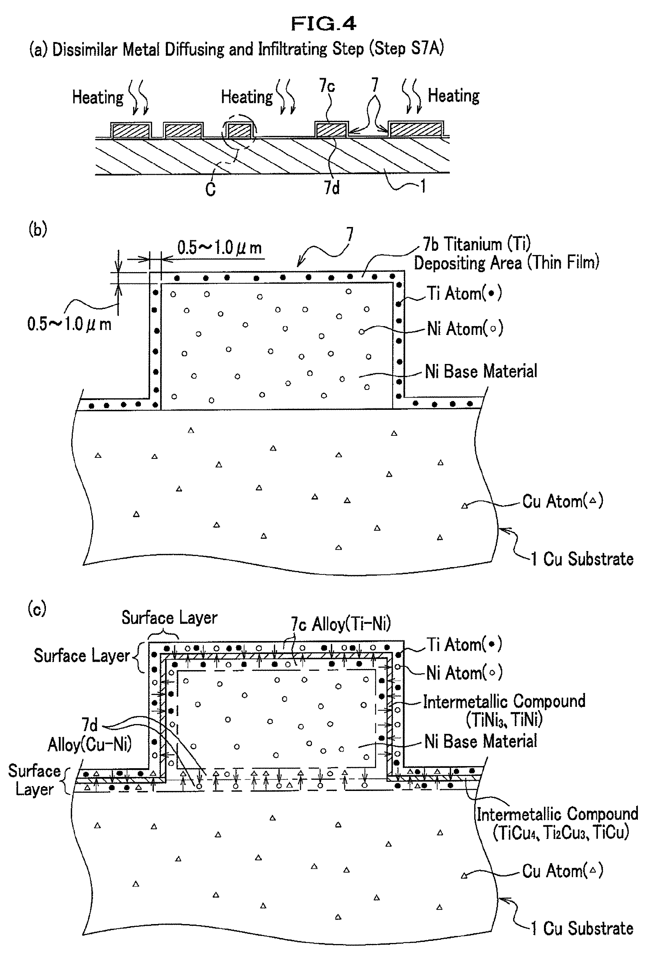

Fig. 4 includes (a), (b) (c) and (d), in which (a) explains a dissimilar metal (titanium (Ti)) diffusing and infiltrating step in the producing method of the spiral contact according to the first embodiment, (c) is an enlarged schematic illustration of the portion C shown in (a) , and (b) is an enlarged schematic illustration of (d) of Fig. 3;

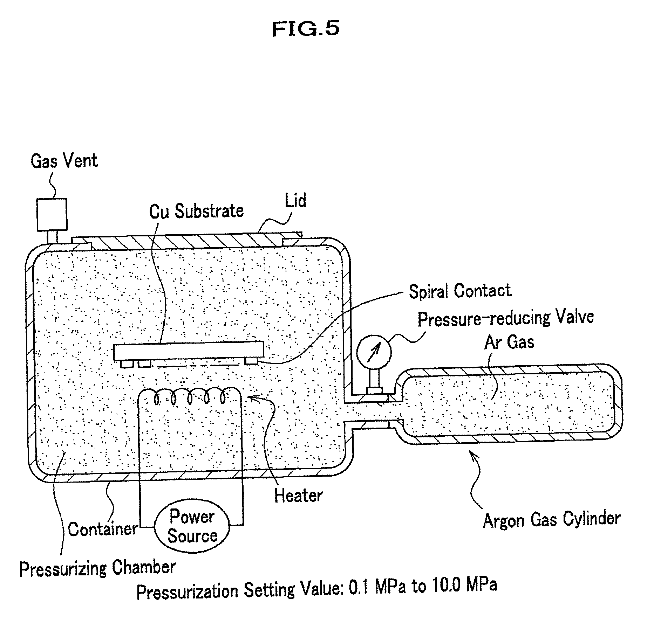

Fig. 5 is a cross section showing an example of a heating and pressurizing method in the producing method of the spiral contact according to the first embodiment;

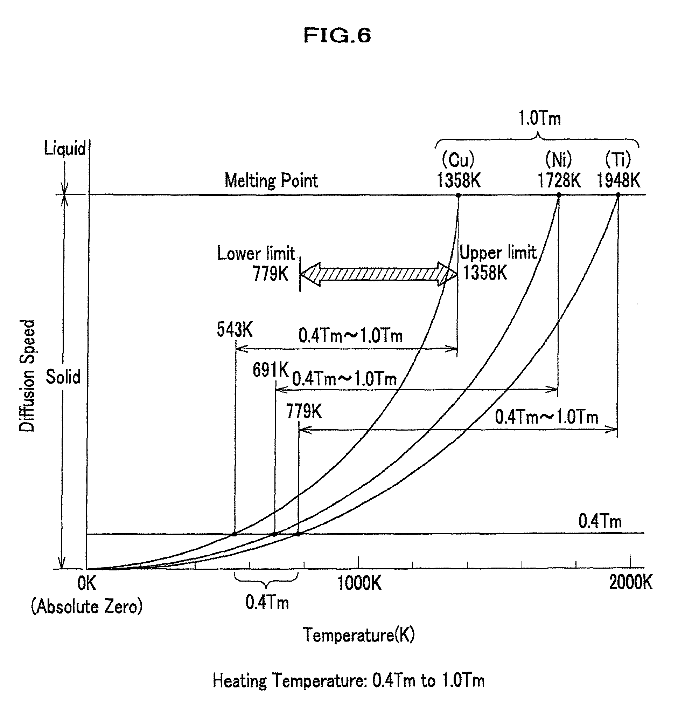

Fig. 6 is a metal phase diagram (where the temperature is expressed in absolute temperature scale) which shows a relationship between the heating temperature and the metal state in the producing method of the spiral contact according to the first embodiment;

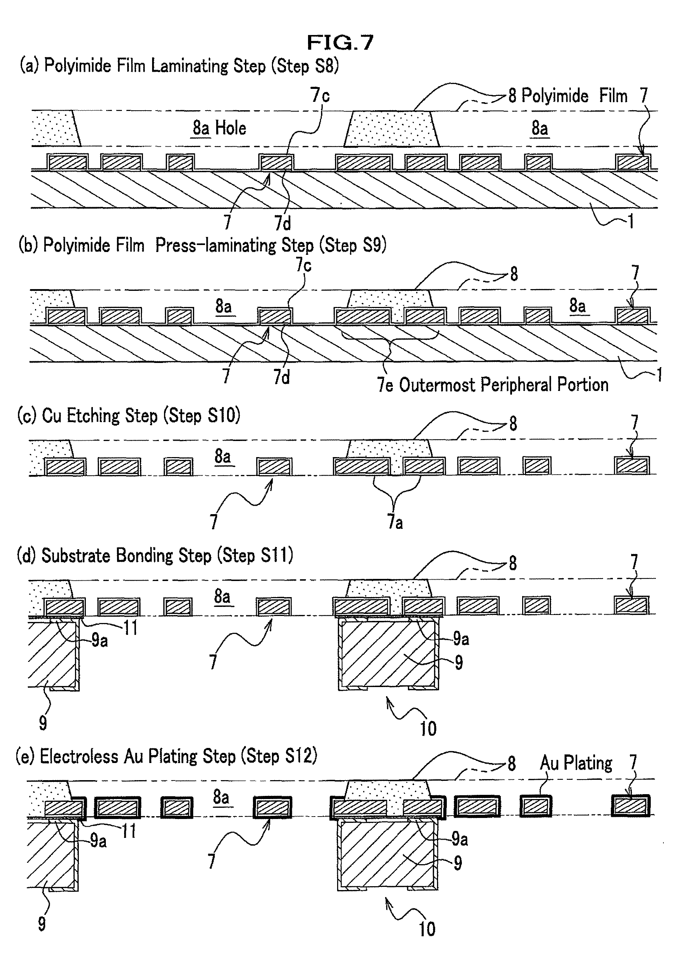

Fig. 7 is a process cross section explaining the producing method of the spiral contact according to the first embodiment, in which (a) explains a polyimide film laminating step, (b) explains a polyimide press-laminating step, (c) explains a Cu etching step, (d) explains a substrate bonding step, and (e) explains an electroless Au plating step;

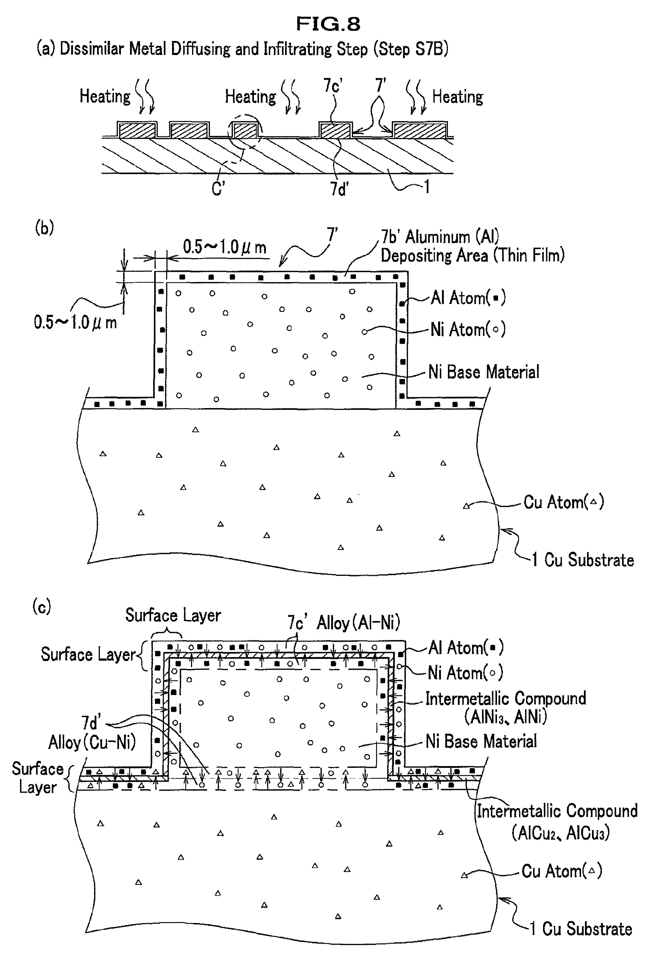

Fig. 8 includes (a), (b) and (c), in which (a) explains a dissimilar metal diffusing and infiltrating step in the producing method of the spiral contact according to a second embodiment, (b) is an enlarged schematic illustration showing a state before the diffusion and infiltration is performed, and (c) is an enlarged schematic illustration of the portion C' shown in (a);

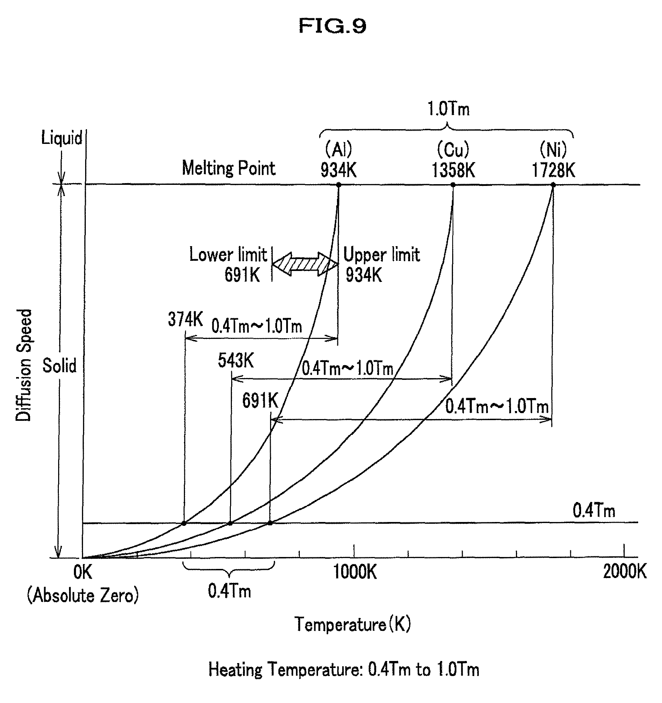

Fig. 9 is a metal phase diagram (where the temperature is expressed in absolute temperature scale) which shows a relationship between the heating temperature and the metal state in the producing method of the spiral contact according to the second embodiment;

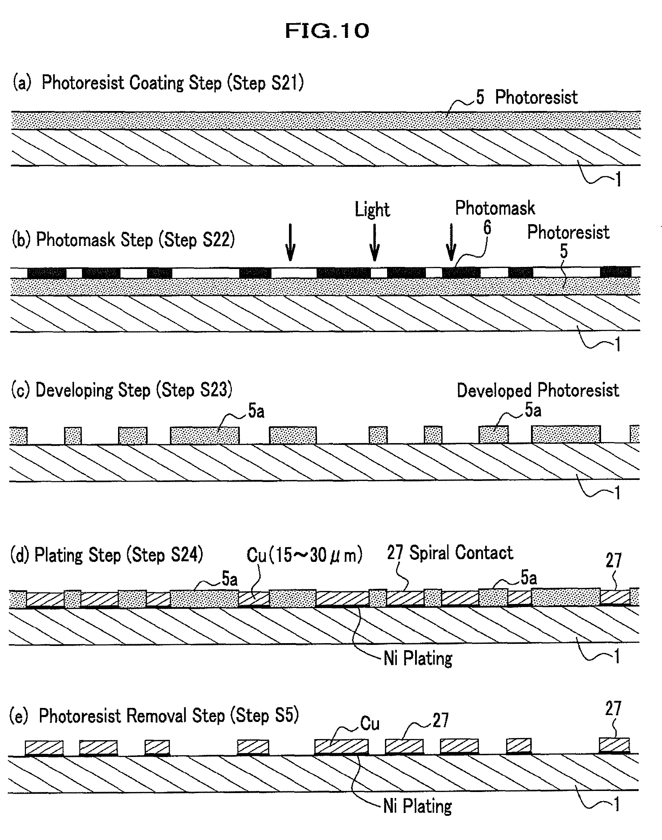

Fig. 10 is a process cross section explaining the producing method of the spiral contact according to a third embodiment, in which (a) explains a photoresist coating step, (b) explains a photomask step, (c) explains a developing step, (d) explains a plating step, and (e) explains a photoresist removal step;

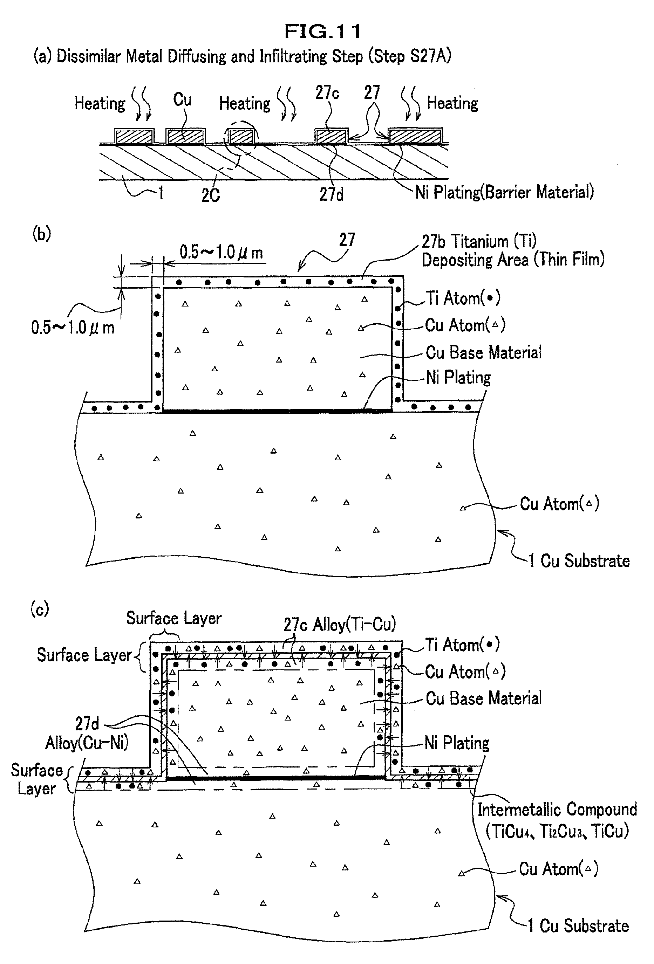

Fig. 11 includes (a), (b) and (c), in which (a) explains a dissimilar metal diffusing and infiltrating step in the producing method of the spiral contact according to the third embodiment, (b) is an enlarged schematic illustration showing a state before the diffusion and infiltration is performed, and (c) is an enlarged schematic illustration of a portion 2C shown in (a);

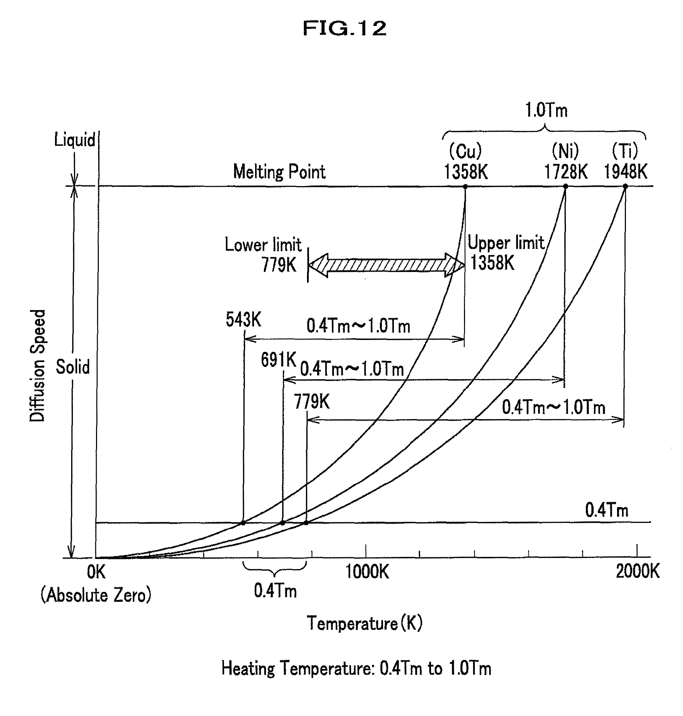

Fig. 12 is a metal phase diagram (where the temperature is expressed in absolute temperature scale) which shows a relationship between the heating temperature and the metal state in the producing method of the spiral contact according to the third embodiment;

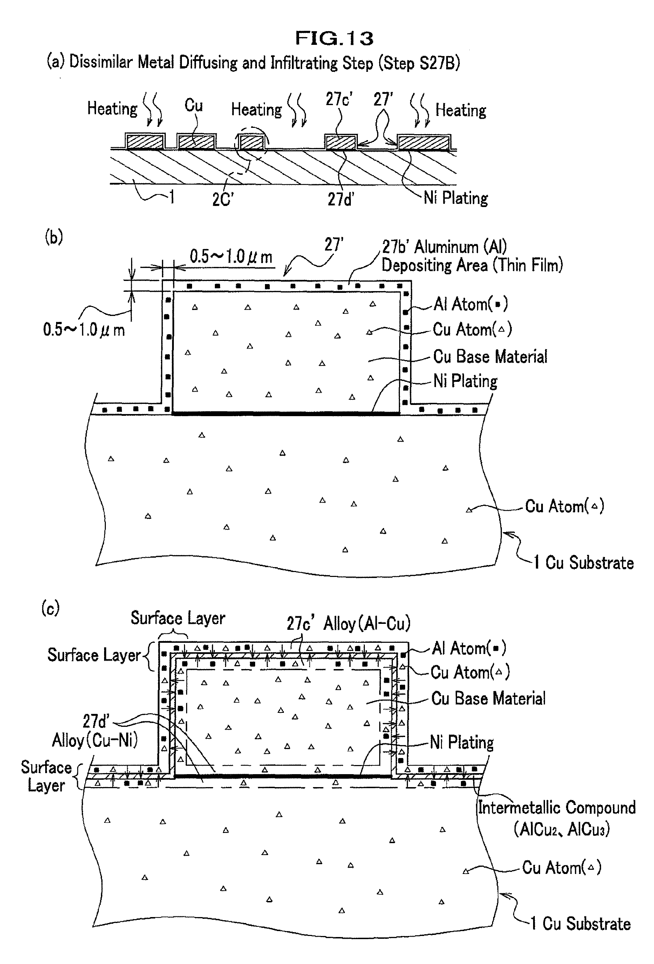

Fig. 13 includes (a), (b) and (c), in which (a) explains a dissimilar metal diffusing and infiltrating step in a producing method of the spiral contact according to a fourth embodiment, (b) is an enlarged schematic illustration showing a state before the diffusion and infiltration is performed, and (c) is an enlarged schematic illustration of a portion 2C' shown in (a) ;

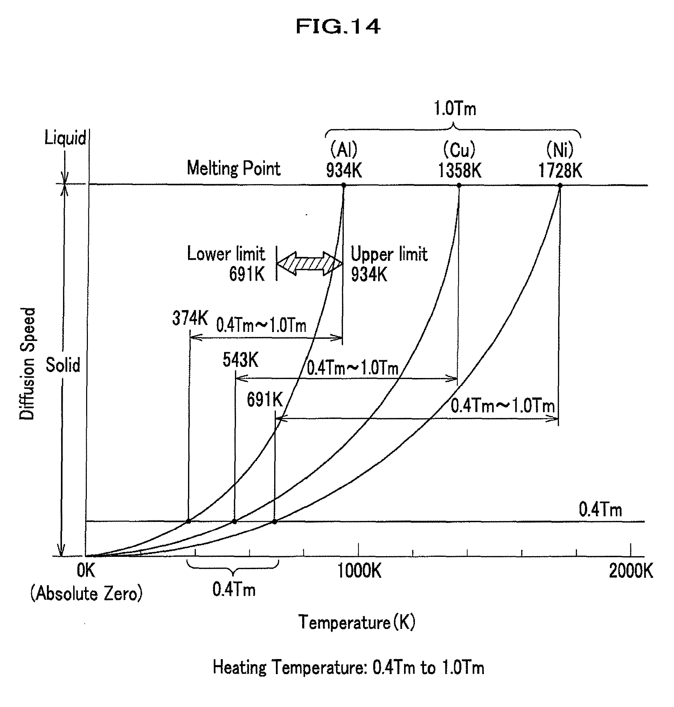

Fig. 14 is a metal phase diagram (where the temperature is expressed in absolute temperature scale) which shows a relationship between the heating temperature and the metal state in the producing method of the spiral contact according to the fourth embodiment;
Fig. 15 is an enlarged perspective view showing a male terminal and a female terminal to electrically connect with each other according to a prior art.
Fig. 16 shows a surface of a Cu alloy substrate forming the terminals shown in Fig. 15, the surface having a plating layer and an alloy formed by thermal diffusion.

### [Best Mode for Carrying out the Invention]

### <First Embodiment>

A spiral contact according to a first embodiment will be described below with reference to the attached drawings.
In Fig. 1, (a) is a perspective view schematically showing the spiral contact according to the first embodiment, (b) and (c) show a cross section taken along line A-A of (a). Further, in Fig. 1, (b) is a cross section showing horizontally positioned spiral contacts, and (c) is a cross section showing a state where a semiconductor device having spherical connection terminals (also referred to as solder balls hereinafter) is inserted into the respective spiral contacts shown in (b), the spherical connection terminals pressing the respective spiral contacts so as to be accurately brought into contact with the respective spiral contacts.

As shown in (a) of Fig. 1, spiral contacts 7 are insulated from each other by a guide frame 8 (a polyimide plate or polyimide film). Further, the spiral contacts 7 are horizontally positioned and held by the guide frame 8, and supported by a board 9.
Incidentally, an arrangement constituted by a plurality of the spiral contacts is referred to as a spiral contactor 10.
The spiral contactor 10 is installed, for example, in such a manner in which the spiral contacts 7, 7, ... 7 thereof are arranged in positions corresponding to spherical connection terminals 2 arranged in a grid pattern on a lower surface of a semiconductor device (IC chip) 4 as shown in (c) of Fig. 1.
Further, though contact length of the wound spiral contact 7 is 1.5 times the rotation herein, the contact length can be properly changed in accordance with the size of the spherical connection terminal 2.

As shown in (b) of Fig. 1, the spiral contact 7 has a flat spiral (wound) shape when left alone, and the width of the spiral gradually increases from the tip of the spiral toward its root. A base material nickel (Ni) is used as a core material for forming the spiral contact 7. A dissimilar metal is diffused and infiltrated into a surface layer of nickel (the core metal). The dissimilar metal is a metal different from the dissimilar metal nickel. The dissimilar metal may be, for example, titanium (Ti), aluminum (Al) or the like, so that the spiral contact 7 also has the characteristic of the alloy of the core metal and the dissimilar metal. Further, an electroless Au plating is performed to an surface thereof.

Further, as shown in (c) of Fig. 1, when the spherical connection terminal 2 of the semiconductor device 4 presses the spiral contact 7, the contact portion of the spiral contact 7 with the spherical connection terminal 2 becomes wider from the center toward the outside, and the spiral (wound) is deformed so as to be concaved to embrace the spherical connection terminal 2. Further, since the spiral contact 7 is spirally wound around the spherical connection terminal 2, the larger the contact length of the spiral contact 7 with the spherical connection terminal 2 is, the more reliably the spiral contact and the spherical connection terminal 2 come into contact with each other. And also, when the large contact length of the spiral contact 7 with the spherical connection terminal 2 is large, even if the surface of the spherical connection terminal 2 is contaminated with a foreign matter, the adhered foreign matter can be removed, and an oxide film on the surface of the spherical connection terminal 2 can be scraped because of the sliding movement of the spiral contact, so that stable electrical contact can be achieved.

Herein the diffusion and infiltration of the dissimilar metal will be briefly described below.
If a core metal (referred to as "one metal") having a dissimilar metal (referred to as "the other metal") different therefrom deposited thereon is heated in that state, then the atoms in the contact area between the dissimilar metal and the core metal will swing due to heat energy, and therefore the movement of atoms of the metals will be caused with the help of the holes and the like. In such a case, the atoms move into the metal of the opposite side due to a diffusion phenomenon in which the atoms of the metal on one side move into the metal on the other side across the surfaces of the both metals. At this time, the atoms of the both metals mutually diffuse into each other. The ease of the movement of the atoms due to the diffusion is determined from a diffusion coefficient thereof.
Further, the diffusion and infiltration also can be caused by pressure, in which an interatomic distance between the metals becomes small due to being cold pressed. When the interatomic distance decreases to several Angstroms, since free electrons are communized, the atoms at a crystal lattice point mutually interact with each other due to the mutual movement of the metal atoms, and therefore the atoms diffuse into the opponent material.

A producing method of the spiral contact according to the present embodiment will be described below.
Fig. 2, Fig. 3 and Fig. 4 are process cross sections explaining the producing method of the spiral contact according to the present embodiment.
In Fig. 2, (a) explains a photoresist coating step (Step S1). As shown in (a) of Fig. 2, a photoresist 5 is uniformly coated on an upper surface of the copper foil (Cu substrate) 1.

In Fig. 2, (b) explains a photomask step (Step S2). As shown in (b) of Fig. 2, a photomask 6 patterned into the same shape as the spiral contact 7 (see Fig. 1) is covered on an upper surface of the photoresist 5, and the image of the photomask 6 is printed in a contact manner. Incidentally, the photomask 6 also can be exposed at a suitable magnification by projecting light onto the photomask 6.

In Fig. 2, (c) explains a developing step (Step S3). As shown in (c) of Fig. 2, after the photoresist 5 (see (b) of Fig. 2) is developed and a photoresist film is formed, places covered by the photomask 6 (black painted places in (b) of Fig. 2) have no photoresist film formed thereon, and therefore the copper foil 1 is exposed in those places. On the other hand, in places not covered by the photomask 6, a developed photoresistdeveloped photoresist film 5a is formed on the exposed copper foil 1 so as to form a reverse image (negative image) of the spiral contact 7.

In Fig. 2, (d) explains a plating step (Step S4) . As shown in (d) of Fig. 2, the metal material nickel (Ni) is plated and deposited only onto the places where the copper foil 1 is exposed so as to form the spiral contact 7. On the other hand, nothing is plated and deposited into the places where the developed photoresist film 5a) is formed.
As a result, the nickel (Ni) is plated onto the places not being exposed owing to the provision of the photomask 6 and having no developed photoresist 5a fixed thereon, so that the spiral contact 7 is formed as if the photomask 6 is traced. In this step, the shape of the spiral contact 7 is precisely painted on the surface of the copper foil 1 by using photoengraving (printing) technology.
Incidentally, the thickness of the Ni plating layer is 15 to 30 *µ*m.

In Fig. 2, (e) explains a photoresist removal step (Step S5). As shown in (e) of Fig. 2, by removing the photoresist, only the spiral contact 7 remains on the surface of the copper foil 1.

In Fig. 3, (a) explains a dissimilar metal depositing step (Step S6). As shown in (a) of Fig. 3, by using a sputtering method, Ti atoms are deposited onto the upper surface of the spiral contact 7 formed in Step 5. Herein, the spiral contact 7 is formed on the Cu substrate 1, and the Cu substrate 1 is fixed to an anode 13 of a sputtering system 12 in a manner in which the surface having the spiral contact 7 formed thereon faces a cathode 14.

In the sputtering method, when a high negative voltage is applied to a target 17 attached to the cathode 14 and argon gas is blown into a vacuum chamber 16, due to the high electric field, the argon gas will become plasma state and will be plus ionized. When a DC voltage is applied between the anode 13 and the cathode 14, argon ions (Ar⁺) accelerated to a high speed hit the target 17. Such a process is performed for a period of from 30 minutes to 2 hours. A magnetic field caused by a magnet on the cathode 14 side serves to improve sputtering efficiency.
Incidentally, although the thin film is formed by the sputtering method which is a kind of PVD (Physical Vapor Deposition) here, the thin film also can be formed by other methods such as a vacuum vapor deposition method.

In Fig. 3, (b) is a process cross section showing a state
where Ti atoms are deposited on the surface of the base material nickel (Step 6A). As shown in (b) of Fig. 3, a thin film 7b of Ti atoms is uniformly deposited on the surface of the base material nickel (see (c) of Fig. 3) and the surface of the Cu substrate 1.

In Fig. 3, (c) is an enlarged schematic illustration of a portion C shown in (b). As shown in (c) of Fig. 3, Ti atoms (dissimilar metal) are deposited on the surface of the base material nickel (Ni) which forms the spiral contact 7. Further, Ti atoms are also deposited on the surface of the Cu substrate 1 in the same manner.
In other words, as shown in (a) of Fig. 3, the argon ions hit the target 17 so that Ti atoms are emitted from the target 17 to deposit on the spiral contact 7, and thereby the thin film 7b of titanium (Ti) is formed on the side surfaces and upper surface of the spiral contact 7 as shown in (b) and (c) of Fig. 3.

In Fig. 3, (d) is a process cross section showing a state
where aluminum (Al) atoms are deposited on the surface of the base material nickel (Ni) (Step 6B). As shown in (d) of Fig. 3, a thin film 7b' of the Al atoms is uniformly deposited on the surface of the base material nickel (see (e) of Fig. 3) and surface of the Cu substrate 1.

In Fig. 3, (e) is an enlarged schematic illustration of a portion C' shown in (d). As shown in (e) of Fig. 3, Al atoms (dissimilar metal) are deposited on the surface of the base material nickel (Ni) which forms the spiral contact 7'. Further, Al atoms are also deposited on the surface of the Cu substrate 1 in the same manner. The details regarding the deposition of aluminum (Al) will be described later in the second embodiment.

In Fig. 4, (a) explains a dissimilar metal diffusing and infiltrating step (Step S7A). In Fig. 4, (b) is an enlarged schematic illustration of (c) of Fig. 3, and (c) is an enlarged schematic illustration of a portion C shown in (a) of Fig. 4.
As shown in (b) of Fig. 4, the nickel (Ni) plating forms the base material (core material) of the spiral contact 7. As mentioned above, Ti atoms are deposited on the side surfaces and upper surface of the spiral contact 7 by the sputtering method (Ti depositing area 7b).
Further, the Cu substrate 1 of the dissimilar metal (Cu) exists below the lower surface of the spiral contact 7.

As shown in (c) of Fig. 4, by heating Ti atoms deposited on the base material nickel and the Cu substrate 1, Ti atoms are diffused and infiltrated into the upper surface and side surfaces of the base material nickel (Ni). In other words, Ti atoms (as the dissimilar metal) are diffused and infiltrated into the surface layer of the base material nickel (Ni) , so that an alloy of nickel (Ni) and titanium (Ti) (namely, a dissimilar metal diffusing and infiltrating area) 7c is formed in this surface layer. Further, due to the existence of the Cu substrate below the spiral contact 7, Cu atoms (as the dissimilar metal) are diffused and infiltrated into the lower surface of the spiral contact 7, so that the alloy of nickel (Ni) and copper (Cu) (namely, a dissimilar metal diffusing and infiltrating area) 7d is formed.
Further, in the boundary between the alloy (the dissimilar metal diffusing and infiltrating area) 7c and the alloy (the dissimilar metal diffusing and infiltrating area) 7d, an alloy of nickel (Ni), titanium (Ti) and copper (Cu) is partially formed.
Further, intermetallic compounds TiNi₃ and TiNi are formed in the boundary (Ti-Ni) of the dissimilar metal.
Further, intermetallic compounds TiCu₄, TiCuNi₃ and TiCu are formed in the boundary (Ti-Cu) of the dissimilar metal.

Fig. 5 is a cross section showing an example of a heating and pressurizing method. As shown in Fig. 5, the pressurization setting value is set to be ≥0.1 MPa but ≤10.0 MPa. Considering the productivity, the pressurization setting value is set within such a range that after the diffusion of atoms has been performed for about 30 minutes, the alloy will only be formed in the surface layer of the spiral contact. Further, in the pressurizing chamber, heating is performed by using a heater. Incidentally, an argon gas cylinder of 10.0 MPa is used as a pressurizing source.
Incidentally, although the diffusion and infiltration of atoms can be accomplished in a short time under pressure, the diffusion and infiltration of atoms also can be accomplished by being heated under the normal pressure (atmospheric pressure).

Fig. 6 is a metal phase diagram (where the temperature is expressed in absolute temperature scale) which shows a relationship between the heating temperature and the metal state. In a pressurized environment, Ti, Ni and Cu are heated in a state
where the core metal is brought into contact with the dissimilar metal.
As shown in Fig. 6, the heating temperature is set such that a lower limit thereof is the temperature corresponding to 0.4 times the absolute temperature of the melting point of the metal with the highest melting point among the core metal and dissimilar metal brought in contact with each other while an upper limit thereof is the absolute temperature of the melting point of the metal with the lowest melting point among the core metal and dissimilar metal brought in contact with each other. The above is a condition set to allow the atoms to be diffused only into the surface layer of the spiral contact. Since the metal with the highest melting point is titanium (Ti), the lower limit is set to 779K that equals to 0.4 times the 1948K (which is the melting point of titanium in absolute temperature). Further, since the metal with the lowest melting point is copper (Cu) , the upper limit is set to 1358K (which is the melting point of copper in absolute temperature scale). That is, the lower limit of the heating temperature is set to 779K, and the upper limit of the heating temperature is set to 1358K.
Thus, atoms of dissimilar metal are diffused and infiltrated into the surface layer of the spiral contact, and therefore it becomes possible to obtain the spiral contact which also has the characteristic of the alloy of the dissimilar metal. The heating duration is within a range between 30 minutes to 2 hours.

By forming the alloy in such a manner, since the titanium (Ti) is a diffusion material for improving the spring characteristic and copper (Cu) is a diffusion material for improving the conductivity, the core material is sandwiched at its upper, lower and side surfaces between titanium (Ti) which is the diffusion material for improving the spring characteristic and copper (Cu) which is the diffusion material for improving the conductivity, and further, a multilayer metal compound (multilayer alloy) is formed under high temperature.
Thus, the spring characteristic of the spiral contact 7 is improved by taking in the characteristic of titanium (Ti) (namely, excellent shape memory performance), and the conductivity of the spiral contact 7 is improved by taking in the characteristic of copper (Cu) (namely, excellent conductivity).

In Fig. 7, (a) explains a polyimide film laminating step (Step S8). Herein the description will be given for the alloy of nickel (Ni) and titanium (Ti) (the dissimilar metal diffusing area) 7c and 7d (see (c) of Fig. 4) which are formed by diffusing and infiltrating atoms of titanium (Ti) into the base material nickel (Ni).

As shown in (a) of Fig. 7, a polyimide film 8 having a hole 8a is disposed on the surface of the copper foil (Cu substrate) 1 on which the spiral contact 7 is formed.

In Fig. 7, (b) explains a polyimide press-laminating step (Step S9). As shown in (b) of Fig. 7, the polyimide film 8 is heated and pressed onto the outermost peripheral portion 7e of the spiral contact 7, and the spiral contact 27 is fixed to the back side of the polyimide film 8.

In Fig. 7, (c) explains a Cu etching step (Step S10). As shown in (c) of Fig. 7, the copper foil (Cu substrate) 1 is removed by etching. Thus, the spiral contact 7 can be spirally upraised through the hole 8a of the polyimide film 8 from the back side toward the front side. At this time, the dissimilar metal titanium (Ti) deposited on the Cu substrate by the sputtering method is also removed when the Cu is removed by etching.

In Fig. 7, (d) explains a substrate bonding step (Step S11). As shown in (d) of Fig. 7, a plate (not shown), on which a thermosetting conductive adhesive 11 is thinly and uniformly applied, is brought into contact with a bonding surface 7a (see (c) of Fig. 7) of the outermost peripheral portion 7e (see (b) of Fig. 7) of the spiral contact 7, and therefore the adhesive 11 is transferred to the bonding surface 7a. The spiral contact 7 is brought into contact with a board 9 so that the bonding surface 7a faces a wiring conductor 9a arranged in a predetermined position of the board 9, and the wiring conductor 9a and the bonding surface 7a are made electrically conductive to each other and are heated and pressed onto each other. Thus, the spiral contact 7 is heated and pressed onto the wiring conductor 9a formed on the surface layer of the board 9. At this time, the bonding surface 7a, on which the adhesive 11 (thermosetting epoxy resin) is applied, is firmly stuck to the board 9 by being heated and pressed.

In Fig. 7, (e) explains an electroless Au plating step (Step S12) . As shown in (e) of Fig. 7, the electroless Au plating is performed to the surface of the spiral contact 7. Thus, the spiral contact 7 will not be oxidized, and therefore connection with low electric resistance can be achieved.

### <Second Embodiment>

Next, a spiral contact according to a second embodiment will be described below with reference to the attached drawings. The second embodiment differs from the first embodiment in that: in the first embodiment, the dissimilar metal titanium (Ti) is deposited on the upper surface and side surfaces of the spiral contact, while in the second embodiment, aluminum (Al) is deposited as the dissimilar metal. Incidentally, in the second embodiment, like components are denoted by like numerals as of the first embodiment and the explanation thereof will be omitted.

In Fig. 8, (a) explains a dissimilar metal diffusing and infiltrating step (Step S7B). In Fig. 8, (b) is an enlarged schematic illustration of (e) of Fig. 3, and (c) is an enlarged schematic illustration of the portion C' shown in (a) of Fig. 8.

As shown in (b) of Fig. 8, the nickel (Ni) plating forms the base material (core material) of a spiral contact 7'. Al atoms are deposited on the side surfaces and upper surface of the spiral contact 7' by a sputtering method (Al depositing area 7b').
Further, the Cu substrate 1 (the dissimilar metal) exists below the lower surface of the spiral contact 7'.

As shown in (c) of Fig. 8, by heating the Al atoms deposited on the base material nickel and the Cu substrate 1, Al atoms are diffused and infiltrated into an upper surface and side surfaces of the base material nickel (Ni). In other words, aluminum (Al) (as the dissimilar metal) is diffused and infiltrated into the surface layer of the base material nickel (Ni), so that an alloy of nickel (Ni) and aluminum (Al) (namely, a dissimilar metal diffusing and infiltrating area) 7c' is formed in this surface layer. Further, due to the existence of the Cu substrate below the spiral contact 7', Cu atoms (as the dissimilar metal) are diffused and infiltrated into the lower surface of the spiral contact 7', so that an alloy of nickel (Ni) and copper (Cu) (namely, a dissimilar metal diffusing and infiltrating area) 7d' is formed.
Further, in the boundary between the alloy (dissimilar metal diffusing and infiltrating area) 7c' and the alloy (dissimilar metal diffusing and infiltrating area) 7d', an alloy of nickel (Ni), aluminum (Al) and copper (Cu) is partially formed.
Further, intermetallic compounds AlNi₃ and AlNi are formed in the boundary (Al-Ni) of the dissimilar metal.
Further, intermetallic compounds AlCu₂ and AlCu₃ are formed in the boundary (Al-Cu) of the dissimilar metal.

Fig. 9 is a metal phase diagram (where the temperature is expressed in absolute temperature scale) which shows a relationship between the heating temperature and the metal state. In a pressurized environment, Al, Ni and Cu are heated in a state
where the core metal is brought into contact with the dissimilar metal.
As shown in Fig. 9, the heating temperature is set such that a lower limit thereof is the temperature corresponding to 0.4 times the absolute temperature of the melting point of the metal with the highest melting point among the core metal and dissimilar metal brought in contact with each other while an upper limit thereof is the absolute temperature of the melting point of the metal with the lowest melting point among the core metal and dissimilar metal brought in contact with each other. The above is a condition set to allow the atoms to be diffused only into the surface layer of the spiral contact. Since the metal with the highest melting point is nickel (Ni), the lower limit is set to 691K that equals to 0.4 times the 1728K (which is the melting point of nickel in absolute temperature scale). Further, since the metal with the lowest melting point is aluminum (Al), the upper limit is set to 934K (which is the melting point of aluminum in absolute temperature scale) . That is, the lower limit of the heating temperature is set to 691K, and the upper limit of the heating temperature is set to 934K.
Thus, atoms of dissimilar metal are diffused and infiltrated into the surface layer of the spiral contact, and therefore it becomes possible to obtain the spiral contact which also has the characteristic of the alloy of the dissimilar metal. The heating duration is within a range between 30 minutes to 2 hours.

By forming the alloy in such a manner, since the aluminum (Al) is a diffusion material for improving the spring characteristic and copper (Cu) is a diffusion material for improving the conductivity, the core material (Ni) is sandwiched at its upper, lower and side surfaces between aluminum (Al) which is a diffusion material for improving the spring characteristic and copper (Cu) which is a diffusion material for improving the conductivity, and further, a multilayer metal compound (multilayer alloy) is formed under high temperature.
Thus, the spring characteristic of the spiral contact 7' is improved by aluminum (Al) which has good spring characteristic, and the conductivity of the spiral contact 7' is improved by copper (Cu) which has excellent conductivity.
Thereafter, Step S8 to Step S12 (see Fig. 7) of the first embodiment are performed in the same manner as the first embodiment except that aluminum (Al) is substituted for titanium (Ti). Thus, similar to the producing steps of the first embodiment, the polyimide film 8 is disposed on the surface of the spiral contact 7' and the copper foil (Cu substrate) 1 so that the spiral contact 7' is fixed to the back side of the polyimide film 8, and then the copper foil (Cu substrate) 1 is removed by etching. Thus, the spiral contact 7' can be spirally upraised through the hole 8a of the polyimide film 8 from the back side to the front side. At this time, the dissimilar metal aluminum (Al) deposited on the Cu substrate by the sputtering method is also removed when the Cu is removed by etching. Further, the substrate is bonded, and the electroless Au plating is performed.

### <Third Embodiment>

Next, a spiral contact according to a third embodiment will be described below with reference to the attached drawings. The third embodiment differs from the first embodiment in that: in the first embodiment, nickel (Ni) is used as the core metal of the spiral contact, while in the third embodiment, copper (Cu) is used as the core metal of the spiral contact. Incidentally, in the third embodiment, like components are denoted by like numerals as of the first embodiment and the explanation thereof will be omitted.

In Fig. 10, (a) explains a photoresist coating step (Step S21) . As shown in (a) of Fig. 10, the photoresist 5 is uniformly coated on the upper surface of the copper foil (Cu substrate) 1.

In Fig. 10, (b) explains a photomask step (Step S22). As shown in (b) of Fig. 10, the photomask 6 patterned into the same shape as a spiral contact 27 (see the spiral contact 7 of Fig. 1) is covered on the upper surface of the photoresist 5, and the image of the photomask 6 is printed in a contact manner. Incidentally, the photomask 6 also can be exposed at a suitable magnification by projecting light onto the photomask 6.

In Fig. 10, (c) explains a developing step (Step S23). As shown in (c) of Fig. 10, after the photoresist 5 (see (b) of Fig. 10) is developed and a photoresist film is formed, the places covered by the photomask 6 (the black painted places in (b) of Fig. 10) have no photoresist film formed thereon, and therefore the copper foil 1 is exposed in these places. On the other hand, in the places not covered by the photomask 6, a developed photoresist film 5a is formed on the exposed copper foil 1 so as to form a reverse image (negative image) of the spiral contact 27.

In Fig. 10, (d) explains a plating step (Step S24). As shown in (d) of Fig. 10, nickel (Ni) (as a barrier material) is plated only on the places where the copper foil 1 is exposed, and copper (Cu) (as a core metal) is plated and deposited onto the plates where nickel (Ni) is plated so as to form the spiral contact 27. On the other hand, nothing is plated and deposited onto the places where the developed photoresist film 5a) is formed.
As a result, the copper (Cu) is plated onto the places not being exposed owing to the provision of the photomask 6 and having no developed photoresist 5a fixed thereon, so that the spiral contact 27 is formed as if the photomask 6 is traced. In this step, the shape of the spiral contact 27 is precisely formed on the surface of the copper foil 1 by using photoengraving (printing) technology.
Incidentally, the thickness of the Cu plating layer is 15 to 30 *µ*m. The thickness of the Ni plating layer is about 0.5 *µ*m.

In Fig. 10, (e) explains a photoresist removal step (Step S25). As shown in (e) of Fig. 10, by removing the photoresist, only spiral contact 27 remains on the surface of the copper foil 1.

In Fig. 11, (a) explains a dissimilar metal diffusing and infiltrating step (Step S27A). In Fig. 11, (b) is an enlarged schematic illustration before the diffusion and infiltration is performed, and (c) is an enlarged schematic illustration of the portion 2C shown in (a) of Fig. 11.
As shown in (b) of Fig. 11, the copper (Cu) plating forms the base material (core material) of the spiral contact 27. As mentioned above, Ti atoms are deposited on the side surfaces and upper surface of the spiral contact 27 by the sputtering method (Ti depositing area 27b).
Further, the Cu substrate 1 of the dissimilar metal (Cu) exists below the lower surface of the spiral contact 27.

As shown in (c) of Fig. 11, by heating Ti atoms and the Ni plating deposited on the base material Cu, and the Cu substrate 1, Ti atoms are diffused and infiltrated into the upper surface and side surfaces of the base material copper (Cu). In other words, Ti atoms (as dissimilar metal) are diffused and infiltrated into the surface layer of the base material copper (Cu), so that an alloy of copper (Cu) and titanium (Ti) (namely, a dissimilar metal diffusing and infiltrating area) 27c is formed in this surface layer. Further, due to the existence of the Ni plating below the spiral contact 27, nickel atoms (as dissimilar metal) are diffused and infiltrated into the lower surface of the spiral contact 27, so that an alloy of copper (Cu) and nickel (Ni) (namely, a dissimilar metal diffusing and infiltrating area) 27d is formed.
Further, intermetallic compounds TiCu₄, TiCuNi₃ and TiCu are formed in the boundary (Ti-Cu) of the dissimilar metal.

Fig. 12 is a metal phase diagram (where the temperature is expressed in absolute temperature scale) which shows a relationship between the heating temperature and the metal state. In a pressurized environment, Ti, Ni and Cu are heated in a state
where the core metal is brought into contact with the dissimilar metal.
As shown in Fig. 12, the heating temperature is set such that a lower limit thereof is the temperature corresponding to 0.4 times the absolute temperature of the melting point of the metal with the highest melting point among the core metal and dissimilar metal brought in contact with each other while an upper limit thereof is the absolute temperature of the melting point of the metal with the lowest melting point among the core metal and dissimilar metal brought in contact with each other. The above is a condition set to allow the atoms to be diffused only into the surface layer of the spiral contact. Since the metal with the highest melting point is titanium (Ti), the lower limit is set to 779K that equals to 0.4 times the 1948K (which is the melting point of titanium in absolute temperature scale) . Further, since the metal with the lowest melting point is copper (Cu) , the upper limit is set to 1358K (which is the melting point of copper in absolute temperature scale). That is, the lower limit of the heating temperature is set to 779K, and the upper limit of the heating temperature is set to 1358K.
Thus, atoms of the dissimilar metal are diffused and infiltrated into the surface layer of the spiral contact 27, and therefore it becomes possible to obtain the spiral contact 27 which also has the characteristic of the alloy of the dissimilar metal. The heating duration is within a range between 30 minutes to 2 hours.

By forming the alloy in such a manner, since the titanium (Ti) is a diffusion material for improving the spring characteristic and copper (Cu) is a diffusion material for improving the conductivity, the core material itself is excellent in conductivity, and the core material (Cu) is sandwiched at its upper, lower and side surfaces by titanium (Ti) which is a diffusion material for improving the spring characteristic, and further, a multilayer metal compound (multilayer alloy) is formed under high temperature. Ni plating is performed to the lower side of the core material (base material Cu). The Ni plating is used as a barrier material so that the core material is formed by copper (Cu).
Thus, the spring characteristic of the spiral contact 27 is improved by taking in the characteristic of titanium (Ti) (namely, excellent shape memory performance), and the conductivity of the spiral contact 27 is improved by taking in the characteristic of copper (Cu) (namely, excellent conductivity).
Thereafter, Step S8 to Step S12 of the first embodiment (see Fig. 7) are performed in the same manner as the first embodiment except that the base material copper (base material Cu) is substituted for the base material nickel (base material Ni) as the core metal. Thus, similar to the producing steps of the first embodiment, the polyimide film 8 is disposed on the surface of the spiral contact 27 and the copper foil (Cu substrate) 1 so that the spiral contact 27 is fixed to the back side of the polyimide film 8, and then the copper foil (Cu substrate) 1 is removed by etching. Thus, the spiral contact 7 can be spirally upraised through the hole 8a of the polyimide film 8 from the back side toward the front side. At this time, the dissimilar metal titanium (Ti) deposited on the Cu substrate by the sputtering method is also removed when the Cu is removed by etching. Further, the substrate is bonded, and the electroless Au plating is performed.

### <Fourth Embodiment>

Next, a spiral contact according to a fourth embodiment will be described below with reference to the attached drawings. The fourth embodiment differs from the third embodiment in that: in the third embodiment, the dissimilar metal titanium (Ti) is deposited on the upper surface and side surfaces of the spiral contact, while in the fourth embodiment, aluminum (Al) is deposited as the dissimilar metal. Incidentally, in the fourth embodiment, like components are denoted by like numerals as of the third embodiment and the explanation thereof will be omitted.

In Fig. 13, (a) explains a dissimilar metal diffusing and infiltrating step (Step S27B). In Fig. 13, (b) is an enlarged schematic illustration before the diffusion and infiltration is performed, and (c) is an enlarged schematic illustration of the portion 2C' shown in (a) of Fig. 13.

As shown in (b) of Fig. 13, the copper (Cu) plating forms the base material (core material) of the spiral contact 27'. Al atoms are deposited on the side surfaces and upper surface of the spiral contact 27' by the sputtering method (Al depositing area 27b').
Further, the Cu substrate 1 of the dissimilar metal (Cu) exists below the lower surface of the spiral contact 27'.

As shown in (c) of Fig. 13, by heating Al atoms and the Ni plating deposited on the base material Cu, and the Cu substrate 1, Al atoms are diffused and infiltrated into the upper surface and side surfaces of the base material copper (Cu). In other words, aluminum (Al) (as dissimilar metal) is diffused and infiltrated into the surface layer of the base material copper (Cu), so that an alloy of copper (Cu) and aluminum (Al) (namely, a dissimilar metal diffusing and infiltrating area) 27c' is formed in this surface layer. Further, due to the existence of the Ni plating below the spiral contact 27', nickel atoms (as dissimilar metal) are diffused and infiltrated into the lower surface of the spiral contact 27', so that an alloy of copper (Cu) and nickel (Ni) (namely, a dissimilar metal diffusing and infiltrating area) 27d' is formed.
Further, intermetallic compounds AlCu₂ and AlCu₃ are formed in the boundary (Al-Cu) of the dissimilar metal.

Fig. 14 is a metal phase diagram (where the temperature is expressed in absolute temperature scale) which shows a relationship between the heating temperature and the metal state. In a pressurized environment, Al, Ni and Cu are heated in a state
where the core metal is brought into contact with the dissimilar metal.
As shown in Fig. 14, the heating temperature is set such that a lower limit thereof is the temperature corresponding to 0.4 times the absolute temperature of the melting point of the metal with the highest melting point among the core metal and dissimilar metal brought in contact with each other while an upper limit thereof is the absolute temperature of the melting point of the metal with the lowest melting point among the core metal and dissimilar metal brought in contact with each other. The above is a condition set to allow the atoms to be diffused only into the surface layer of the spiral contact. Since the metal with the highest melting point is nickel (Ni), the lower limit is set to 691K that equals to 0.4 times the 1728K (which is the melting point of nickel in absolute temperature scale). Further, since the metal with the lowest melting point is aluminum (Al), the upper limit is set to 934K (which is the melting point of aluminum in absolute temperature scale). That is, the lower limit of the heating temperature is set to 691K, and the upper limit of the heating temperature is set to 934K.
Thus, atoms of the dissimilar metal are diffused and infiltrated into the surface layer of the spiral contact, and therefore it becomes possible to obtain the spiral contact which also has the characteristic of the alloy of the dissimilar metal. The heating duration is within a range between 30 minutes to 2 hours.

By forming the alloy in such a manner, since the aluminum (Al) is a diffusion material for improving the spring characteristic and copper (Cu) is a diffusion material for improving the conductivity, the core material itself is excellent in conductivity, and the core material (Cu) is sandwiched at its upper, lower and side surfaces by aluminum (Al) which is a diffusion material for improving the spring characteristic, and further, a multilayer metal compound (multilayer alloy) is formed under high temperature. Ni plating is performed to the lower side of the core material (base material Cu). The Ni plating is used as a barrier material so that the core material is formed by copper (Cu).
Thus, the spring characteristic of the spiral contact 27' is improved by aluminum (Al) which has good spring characteristic, and the conductivity of the spiral contact 27' is improved by copper (Cu) which has excellent conductivity.
Thereafter, Step S8 to Step S12 of the first embodiment (see Fig. 7) are performed in the same manner as the first embodiment except that the base material copper (base material Cu) is substituted for the base material nickel (base material Ni) as the core metal. Thus, similar to the producing steps of the first embodiment, the polyimide film 8 is disposed on the surface of the spiral contact 27' and the copper foil (Cu substrate) 1 so that the spiral contact 27' is fixed to the back side of the polyimide film 8, and then the copper foil (Cu substrate) 1 is removed by etching. Thus, the spiral contact 7 can be spirally upraised through the hole 8a of the polyimide film 8 from the back side toward the front side. At this time, the dissimilar metal aluminum (Al) deposited on the Cu substrate by the sputtering method is also removed when the Cu is removed by etching. Further, the substrate is bonded, and the electroless Au plating is performed.

Although the preferable embodiments are described above, the present invention is not limited to the above embodiments but various changes can be made without departing from the spirit of the invention. For example, although the thin film is formed by the sputtering method when depositing the film of the dissimilar metal onto the core metal, the thin film also can be formed by other methods, such as chemical vapor deposition (CVD) and other kind of physical vapor deposition (PVD), instead of being limited to the sputtering method as long as the thin film can be formed.
Further, although the polyimide film is disposed on the surface of the copper foil, on which the spiral contact is formed, in the polyimide film laminating step, the polyimide resin also can be applied by coating.
Further, dissimilar metals to be diffused and infiltrate into the surface layer of the spiral contact can be others selected from Cu, Ag, Ni, Zn, P, B, Cr, Mn, Fe, Co, Pd, Pt, Ti, Zr, Hf, V, Nb, Ta, Mo, W, In, C, S, Au, Al, Si, Sb, Bi and Te. Particularly, the element B is preferable to be added to the other dissimilar metals to form an alloy.
Further, although the diffusion and infiltration of atoms is mainly performed in a pressurized environment, it also can be accomplished by being heated under the normal pressure (atmospheric pressure) though it will take a little longer time.

## Claims

1. A producing method of a spiral contact in which at least one dissimilar metal different from a core metal of the spiral contact is diffused and infiltrated into a surface layer of the core metal, wherein atoms of the dissimilar metal are diffused and infiltrated into the surface layer of the core metal by being heated in a state where the core metal is brought into contact with the dissimilar metal.

2. A producing method of a spiral contact in which at least one dissimilar metal different from a core metal of the spiral contact is diffused and infiltrated into a surface layer of the core metal, wherein atoms of the dissimilar metal are diffused and infiltrated into the surface layer of the core metal by being heated in a pressurized environment in a state where the core metal is brought into contact with the dissimilar metal.

3. The producing method of the spiral contact according to claim 1 or 2, wherein the heating temperature is set such that a lower limit thereof is the temperature corresponding to 0.4 times the absolute temperature of the melting point of the metal with the highest melting point among the core metal and the dissimilar metal brought in contact with each other while an upper limit thereof is the absolute temperature of the melting point of the metal with the lowest melting point among the core metal and the dissimilar metal brought in contact with each other.

4. The producing method of the spiral contact according to claim 2, wherein the pressure of the pressurized environment is set to be ≥0.1 MPa but ≤10.0 MPa.

5. The producing method of the spiral contact according to claim 1 or 2, wherein the dissimilar metal is titanium (Ti) which is deposited onto the surface of the core metal by a physical vapor deposition.

6. The producing method of the spiral contact according to claim 1 or 2, wherein the dissimilar metal is aluminum (Al) which is deposited onto the surface of the core metal by a physical vapor deposition.

7. The producing method of the spiral contact according to any one of claims 1, 2 and 4, wherein the core metal is constituted by nickel (Ni) plated and deposited on a copper (Cu) substrate, and atoms of copper (Cu) are diffused and infiltrated into the surface layer of the core metal by being heated in a state where the copper (Cu) substrate and the core metal are brought into contact with each other.

8. The producing method of the spiral contact according to claim 1 or 2, wherein if the core metal is constituted by nickel (Ni) plated and deposited on a copper (Cu) substrate and the dissimilar metal is constituted by titanium (Ti), then the heating temperature is between 779K and 1358K.

9. The producing method of the spiral contact according to claim 1 or 2, wherein if the core metal is constituted by nickel (Ni) plated and deposited on a copper (Cu) substrate and the dissimilar metal is constituted by aluminum (Al), then the heating temperature is between 691K and 934K.

10. The producing method of the spiral contact according to any one of claims 1, 2 and 4, wherein the core metal is constituted by copper (Cu) plated and deposited on a barrier material previously plated and deposited on a copper (Cu) substrate, and atoms of the barrier material are diffused and infiltrated into the surface layer of the core metal by being heated in a state where the copper (Cu) substrate, the barrier material and the core metal are laminated.

11. The producing method of the spiral contact according to claim 10, wherein if the barrier material is constituted by a nickel (Ni) plating, the core metal is constituted by copper (Cu) plated and deposited on the nickel (Ni) plating, and the dissimilar metal is constituted by titanium (Ti), then the heating temperature is between 779K and 1358K.

12. The producing method of the spiral contact according to claim 10, wherein if the barrier material is constituted by a nickel (Ni) plating, the core metal is constituted by copper (Cu) plated and deposited on the nickel (Ni) plating, and the dissimilar metal is constituted by aluminum (Al), then the heating temperature is between 691K and 934K.

13. A spiral contact produced by the producing method of the spiral contact according to any one of claims 1, 2, 4, 11 and 12.
